# EUROPEAN PATENT APPLICATION

(11) **EP 4 679 504 A1**
(43) Date of publication of application: **14.01.2026**
(21) Application number: 25188037.3
(22) Date of filing: 08.07.2025
(51) Int. Cl.: H01L 23/42, H01L 25/065

(54) **HETEROGENEOUS THERMAL INTERFACE MATERIAL**

(30) Priority: 08.07.2024 US 202463668669 P; 02.07.2025 US 202519258460
(71) Applicant: Google LLC, Mountain View, CA 94043 (US)
(72) Inventor: Shahidi, Nima, Mountain View, California, 94043 (US); Xie, Weidong, Mountain View, California, 94043 (US); Samadiani, Emad, Cupertino, California, 95014 (US); Tang, Yingshi, Mountain View, California, 94943 (US)
(74) Representative: Betten & Resch

(57) **Abstract**

A chip package assembly includes a first high-power chip, a second low-power chip, a thermal cooling device and a heterogeneous thermal interface material ("HTIM"). The thermal cooling device may overlie the first chip and the second chip. The HTIM includes a first thermal interface material ("TIM") and a second TIM. The first TIM overlies the first chip, and the second TIM overlies the second chip. The first TIM includes a material that has a first thermal conductivity and a first modulus of elasticity. The first TIM can reflow when the first die reaches a first TIM reflow temperature. The second TIM comprises at least a polymer material. The second TIM has a second modulus of elasticity that is greater than the first modulus of elasticity and a second thermal conductivity that is less than the first thermal conductivity.

## Description

### CROSS REFERENCE TO RELATED APPLICATIONS

The present application claims the benefit of the filing date of U.S. Provisional Patent Application No. 63/668,669, filed July 8, 2024, the disclosure of which is hereby incorporated herein by reference.

### BACKGROUND

Thermal interface materials ("TIMs") are used to improve heat transfer between silicon die and heat sink in electronic devices. TIMs are made of silicone, graphite, metals (or solder), or even phase-changing materials, depending on specific application requirements.

Delamination and pump-out are two significant challenges associated with TIMs. Delamination occurs when the TIM separates away from either the silicon die or the heat sink, leading to a decrease in thermal conductivity. Pump-out refers to the displacement of the TIM in between the heat sink and silicon die surfaces under pressure, also leading to increased operating temperature.

### BRIEF SUMMARY

According to aspects of the disclosure, a heterogeneous thermal interface material ("HTIM" or "heterogeneous TIM") is designed to enhance device performance by optimizing heat transfer in heterogeneous integrated devices. The heterogeneous TIM can be implemented with heterogeneous 2.5D packaging that includes both high power consuming devices, including without limitation logic, and low power devices, including without limitation, memory, integrated onto a single substrate. The distance of each device from the neutral point of the substrate can lead to varying mechanical stresses on the thermal interface material. Devices positioned farther from the neutral point may experience greater mechanical strain, highlighting the importance of selecting a TIM with suitable mechanical properties to withstand these stresses effectively. The heterogeneous TIM according to aspects of the disclosure can help to minimize strain, delamination, and other shortcomings created by packaged devices, including without limitation, heat generated by components in chip package assemblies. HTIM according to aspects of the disclosure may comprise at least a first TIM and a second TIM, the selection of which can be based on the type of components used in the chip package construction. In a typical chip on wafer on substrate package, the construction of the package may include memory and silicon, such that two differing TIMs can be implemented, in which the two TIMs may have different properties such as different thermal conductivities and/or modulus of elasticity or other differing properties. In some examples, the first TIM and the second TIM may be joined together along a common boundary, including without limitation, abutting one another, diffusing together, contacting one another. In other examples, the first and second TIMs may be spaced apart from one another, such that they do not share a common boundary. In other examples, the first and second TIMs may be spaced apart from one another, such that they do not share a common boundary.

According to an aspect of the disclosure, an integrated circuit ("IC") chip package assembly comprises a substrate, a first IC chip, a second IC chip, a fill material, a thermal cooling device, and heterogeneous thermal interface material ("HTIM"). The first IC chip is coupled to the substrate and generates heat at a first temperature. The second IC chip is spaced apart from and positioned directly adjacent the first IC chip. The second IC chip generates heat at a second temperature less than the first temperature. The fill material is disposed in a gap between the first IC chip and the second IC chip. The thermal cooling device overlies the first IC chip and the second IC chip. The HTIM further comprises a first thermal interface material ("TIM") and a second TIM. The first TIM and the second TIM are positioned adjacent one another such that they form a common edge. The first TIM overlies the first IC chip and the second TIM overlies the second IC chip. The HTIM bonds the first and second IC chips to the thermal cooling device. The first TIM comprises a material having a first thermal conductivity and a first modulus of elasticity. The first TIM reflows when the first TIM reaches a first TIM reflow temperature. The second TIM comprises at least a polymer material, the second TIM having a second modulus of elasticity greater than the first modulus of elasticity and a second thermal conductivity less than the first thermal conductivity

According to another aspect of the disclosure, an integrated circuit ("IC") chip package assembly comprises a substrate, a first high-power logic chip, a plurality of second low-power memory chips, a fill material, and a heterogeneous thermal interface material ("HTIM"). The first high-power logic chip coupled to the substrate and generating heat at a first temperature. The plurality of second low-power memory chips are spaced apart from and positioned laterally adjacent the first IC chip along a same plane, the plurality of second IC chips each generating heat at a second temperature less than the first temperature. The fill material is disposed in gaps between the high-power logic chip and the plurality of second low power memory chips, such that a top surface of the fill material is coplanar with the top surface of the first high-power logic chip and the top surfaces of the plurality of second low-power memory chips. The HTIM comprises a first thermal interface material ("TIM") and a second TIM. The first TIM and the second TIM are positioned adjacent one another such that they form a common edge. The first TIM overlies the first IC chip and the second TIM overlies the plurality of second low-power memory chips. The first TIM comprises a material having a first thermal conductivity and a first modulus of elasticity. The first TIM reflows when the first TIM reaches a first TIM reflow temperature. The second TIM comprises at least a polymer material. The second TIM has a second modulus of elasticity greater than the first modulus of elasticity and a second thermal conductivity less than the first thermal conductivity.

According to an aspect of the disclosure, an integrated circuit ("IC") chip package assembly includes a substrate; a first IC chip; a second IC chip; a thermal cooling device; and a heterogeneous thermal interface material ("HTIM"). The first IC chip may be coupled to the substrate and generate heat at a first temperature. A second IC chip directly adjacent to the first IC chip is coupled to the substrate. The second IC chip generates heat at a second temperature that is less than the first temperature. The thermal cooling device overlies the first IC chip and the second IC chip. The HTIM includes at least a first thermal interface material ("TIM") and a second TIM depending on the type of components used in the chip construction. In a typical chip on wafer on substrate package, the construction of the package may include memory and silicon, such that only two different TIMs are required. In some examples, the first TIM and the second TIM may be joined together, such that they abut one another, diffuse together, or generally contact one another. In other examples, first and second TIMs may be spaced apart from one another. In some examples, the first and second TIM may each have a distinct boundary which is the same size as the underlying IC chip, but in other examples, the first and/or second TIM may extend beyond a peripheral edge of the chip. The first TIM overlies the first IC chip and the second TIM overlies the second IC chip. The first TIM may comprise a material having a first thermal conductivity and a first modulus of elasticity. The first TIM may reflow when the first TIM reaches a first TIM reflow temperature. The second TIM may include at least a polymer material with a viscoelastic property. The second TIM has a second modulus of elasticity that is greater than the first modulus of elasticity and a second thermal conductivity that is less than the first thermal conductivity.

According to an aspect of the disclosure, an integrated circuit ("IC") chip package assembly includes a substrate; a first IC chip; a second IC chip; a thermal cooling device; and a heterogeneous thermal interface material ("HTIM"). The first IC chip may be coupled to the substrate and generate heat at a first temperature. A second IC chip directly adjacent the first IC chip is coupled to the substrate. The second IC chip generates heat at a second temperature less than the first temperature. The thermal cooling device overlies the first IC chip and the second IC chip. The heterogeneous thermal interface material ("HTIM") includes a first thermal interface material ("TIM") and a second TIM. The first TIM and the second TIM are joined together. The first TIM overlies the first IC chip and the second TIM overlies the second IC chip. The HTIM bonds the first and second IC chips to the thermal cooling device. The first TIM may comprise a material having a first thermal conductivity and a first modulus of elasticity. The first TIM may reflow when the first TIM reaches a first TIM reflow temperature. The second TIM may include at least a polymer material. The second TIM has a second modulus of elasticity greater than the first modulus of elasticity and a second thermal conductivity that is less than the first thermal conductivity.

According to another aspect of the disclosure, an integrated circuit ("IC") chip package assembly includes a substrate; a first IC chip coupled to the substrate and generating heat at a first temperature; a second IC chip; a thermal cooling device; and a heterogeneous thermal interface material ("HTIM"). The second IC chip may be directly adjacent to the first IC chip and coupled to the substrate. The second IC chip may generate heat at a second temperature that is less than the first temperature. The thermal cooling device may overlie the first IC chip and the second IC chip. The HTIM includes a first thermal interface material ("TIM") and a second TIM. The first TIM and the second TIM are joined together. The first TIM overlies the first IC chip and the second TIM overlies the second IC chip. The HTIM bonds the first and second IC chips to the thermal cooling device. The first TIM may include a material having a first thermal conductivity and a first modulus of elasticity. The first TIM may diffuse and/or reflow with the second TIM when the second TIM reaches a first diffusion temperature. The second TIM may include at least a polymer material. The second TIM may have a second modulus of elasticity that is greater than the first modulus of elasticity and a second thermal conductivity that is less than the first thermal conductivity.

According to another aspect of the disclosure, a chip package assembly includes a first high-power chip, a second low-power chip, a thermal cooling device and a heterogeneous thermal interface material ("HTIM"). The thermal cooling device may overlie the first chip and the second chip. The HTIM includes a first thermal interface material ("TIM") and a second TIM. The first TIM overlies the first chip, and the second TIM overlies the second chip. The first TIM includes a material that has a first thermal conductivity and a first modulus of elasticity. The first TIM can reflow when the first die reaches a first TIM reflow temperature. The second TIM comprises at least a polymer material. The second TIM has a second modulus of elasticity that is greater than the first modulus of elasticity and a second thermal conductivity that is less than the first thermal conductivity.

### BRIEF DESCRIPTION OF THE DRAWINGS

FIG. 1 depicts a schematic cross-sectional view of an example chip package assembly according to an aspect of the disclosure.
FIG. 2 illustrates a schematic top view of some of the components of the chip package assembly of FIG. 1.
FIGS. 3-4 illustrate schematic top views of components of the chip package assembly of FIG. 1.
FIG. 5 depicts a schematic cross-sectional view of an example chip package assembly according to an aspect of the disclosure.
FIG. 6 illustrates a schematic top view of components of the chip package assembly of FIG. 5.
FIG. 7 illustrates a schematic top view of an arrangement of IC chips of a chip package assembly according to an aspect of the disclosure.
FIGS. 8-9 illustrate a schematic top view of an example heterogenous thermal interface material overlying the IC chips of FIG. 7.
FIG. 10 illustrates a schematic top view of an arrangement of IC chips of a chip package assembly according to an aspect of the disclosure.
FIG. 11 illustrates a schematic top view of an example heterogenous thermal interface material overlying the IC chips of FIG. 10.

### DETAILED DESCRIPTION

The inventive technology is directed to a heterogenous thermal interface material ("HTIM") for a chip device package containing at least one first chip that generates a first amount of heat and at least one second chip that generates a second amount of heat that is less than the amount of heat generated by the first chip. For example, the chip package may include one high-power chip and one lower power chip, where the high-power chip generates an amount of heat that is greater than the amount of heat generated by the low-power chip. As a result, the first chip generates heat at a first temperature and the second chip generates heat at a second temperature that is less than the first temperature. The HTIM may join a thermally conductive device, such as a heat sink, to a heterogenous device package including at least one high-power chip positioned at a neutral axis of the device package and at least one low-power chip positioned further away from the neutral axis than the high-power chip. The improved HTIM is comprised of at least two different TIMs that, as a heterogenous unit, collectively address delamination and/or pump-out by minimizing warping of the overall device package and peripheral dies in the packaged device, as well as enhancing thermal distribution of heat from the at least one high-power chip to the thermally conductive device. The HTIM can be comprised of a first high thermally conductive TIM that can dissipate heat from the high-power chip to the thermally conductive device. The first TIM may comprise a metal material, such as a solder TIM ("STIM") with high thermal conductivity. The HTIM can be further comprised of a second TIM possessing features configured to prevent the reflow of the first TIM onto the directly adjacent or neighboring chip(s) or interconnections that can cause short circuiting of the device from the first TIM. The second TIM may be a polymer material, which can additionally help to minimize delamination due to its viscoelastic behavior and in some examples may also help to minimize warping.

The HTIM may be used across multiple chips in a packaged device or assembly and the arrangement of the HTIM and the selection of material comprising the TIM can allow for maximum cooling and minimal warping of the packaged device, in which at least one chip is a high-power chip and at least one chip is a low-power chip. One example chip package device may include a first high-power chip disposed on a substrate and directly adjacent low-power chips. Example high-power chips can include, without limitation, a server central processing unit ("CPU") chip, application-specific integrated circuit ("ASIC"), graphic processing unit ("GPU"), or tensor processing unit ("TPU"), all of which consume significant power and generate significant heat. In one example, the high-power chip may be positioned at a central portion of the device package along a neutral axis, which is a central axis that extends perpendicular to the major surface of the substrate. Low-power chips, on the other hand, utilize less power and generate less heat. Examples of low-power chips may include memory chips, such as a high bandwidth memory ("HBM") chip. In some examples, a high-power chip in a package assembly may comprise a logic chip, including without limitations, those logic chips described above, and a low-power chip may be a memory chip.

The HTIM may include a first TIM and a second TIM. The first TIM may be positioned to overlie the high-power chip, which generates significant heat. The second TIM may be positioned to overlie a low-power chip that generates less heat than the high-power chip, but that may be positioned further away from the neutral axis where there is greater strain on both the substrate and the low-power chip itself, and an increased likelihood of warping. In some examples, the second TIM may be positioned directly adjacent to the first TIM and the high-power chip. Although not required, the gap between these chips can be filled with a fill material. In some examples, the gap can be filled with fill material so that a top surface of the fill material within the gap is coplanar with top surfaces of the chips adjacent the gap. A continuous planar surface can be formed across and between each of the chips. In some examples, a mold compound material can be used to fill the gaps to achieve coplanarity. In other examples, an underfill may instead be used, which can result in a non-even or non-planar surface. Still other materials can alternatively or additionally be used for fill material.

The first TIM may be a material possessing high thermal conductivity and a low modulus of elasticity. This is because the high-power chip may be positioned along the neutral axis, where warping will be minimal. Further, the high-power chip will generate significant heat. A TIM with a high thermal conductivity can help to effectively transfer heat from the high-power chip to the thermally conductive device. The first TIM may reflow during processing of the package.

A TIM comprising a metal may be selected for the first TIM, which is more rigid when cured, but which becomes less rigid and more fluid when heated. Examples of a metal-based TIM can include a TIM having a thermal conductivity of 50 W/(m·K) to 100 W/(m·K) or 40 W/(m·K) to 110 W/(m·K), or less than 50 W/(m·K), or more than 30 W/(m·K). A solder TIM ("STIM") that possesses high thermal conductivity and that may reflow during operation of the chip package device can be implemented. For example, a solid solder, such as, without limitation, an indium or indium alloy solder can be utilized. In some examples, the first TIM can be deposited across the entire inactive or rear surface of the high-power chip, or at least a majority of the inactive surface of the high-power chip. In some examples, the high thermally conductive TIM can be comprised of metals such as silver or indium possessing a high modulus of elasticity and placed closer to the neutral point of the package to absorb mechanical changes resulting from the high temperatures of the high-power chip and thereby producing less dynamic warpage.

The material comprising the second TIM can be selected to prevent reflow of the first TIM onto the neighboring interconnections of the low-power chip and/or other interconnections which may be present in the chip package assembly and which may short circuit. In some examples, the material comprising the second TIM can include a polymer having a high modulus of elasticity. Such polymers can have low thermal conductivity, such as, without limitation, in the range of 3 W/(m·K) to 10 W/(m·K). In some examples, polymer TIMs can include composites containing an organic polymer material and thermally conductive fillers. Thermally conductive fillers can include, without limitation, carbon, metalloids, and polymers. In this regard, the second TIM can be capable of creating a barrier or shield to prevent the reflow of the first TIM from reaching and short circuiting the low-power chips or other devices and interconnections adjacent the high-power chip. Other examples of polymers can include combinations, such as a polymer-enhanced oil or grease. In some examples, a key characteristic of the second TIM may be the ability to damp the dynamic warpage of the chip as it is positioned further away from the neutral point of the package

Additionally, since the low-power chip does not generate significant heat, the selected second TIM does not need to possess high thermal conductivity or possess a thermal conductivity similar to the first TIM. An optimal second TIM can further be selected based on its modulus of elasticity and the second TIM preferably possesses a high modulus of elasticity. In this regard, the polymer-based second TIM can additionally be selected based on its ability to compensate for warping of the low-power chip and/or substrate underlying the low-power chip during use of the device package.

In some examples, the first TIM may only overlie the high-power chip and the second TIM may only overlie the low-power chip. In other examples, the first TIM may overlie only a portion of the high-power chip and the second TIM may overlie both the low-power chip and a portion of the high-power chip.

Use of an HTIM according to aspects of the disclosure can allow for use of a heterogenous TIM across multiple chips. A first TIM of the HTIM may overlie a high-power chip or a chip operating at high temperatures and that has a high thermal conductivity, as discussed above, to be utilized over an entire surface or a majority of the surface of the high-power chip. Use of a second TIM of the HTIM comprised of another material, including without limitation, a polymer material, can be implemented to prevent reflow of the first TIM onto the low-power chip and/or other components adjacent the first TIM or the high-power chip that may cause short circuiting. This arrangement of the materials comprising the HTIM can allow for improved adhesion properties and resistance to thermal cycling due to the effective transfer of heat from the high-power chip to the thermal cooling device. Additionally, mechanical stability is enhanced to minimize warpage and delamination of the overall chip package device.

### EXAMPLE HTIM

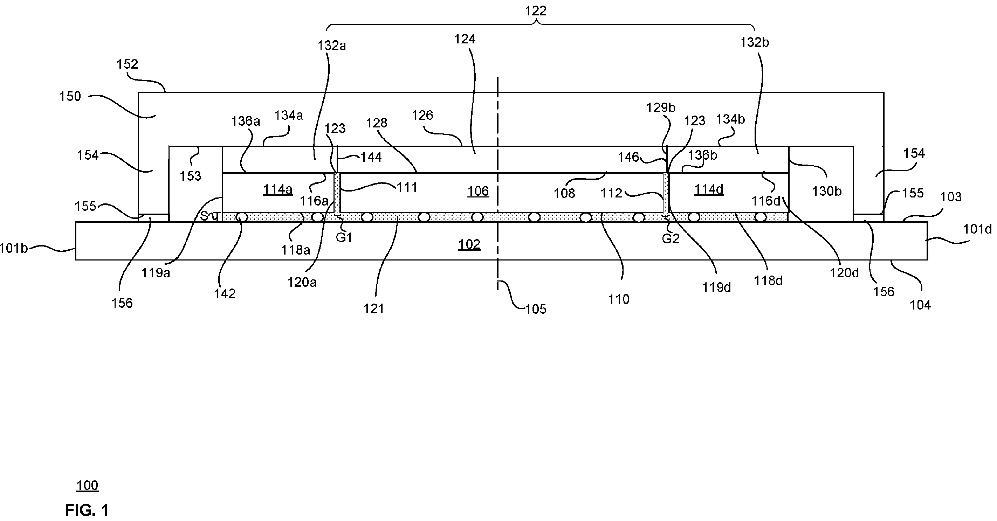

FIG. 1 illustrates an example chip package 100 that incorporates an example heterogeneous thermal interface material ("HTIM") 122 according to an aspect of the disclosure. HTIM 122 may be deposited over multiple integrated circuit ("IC") chips in a packaged device or assembly. The arrangement of HTIM 122 and the selection of TIM materials that comprise HTIM 122 can allow for improved cooling and help minimize warping of chip package 100. Chip package 100 may include a first chip that generates a first amount of heat and a second chip that generates a second amount of heat that is less than the amount of heat generated by the first chip. For example, chip package 100 may include a first chip 106 that is a high-power chip and one or more second chips, such as second chips 114a, 114b, 114c, 114d, 114e, 114f (collectively "second chips 114a-114f" or "second chips 114") that are low-power chips. The high-power chip generates an amount of heat that is greater than the amount of heat generated by the low-power chip. HTIM 122 may include a first TIM 124 that overlies first chip 106 and a second TIM 132a, 132b (collectively "second TIM 132") that overlies second chips 114. Similarly, the high-power chip generates heat at a first temperature and the low-power chip generates heat at a second temperature that is less than the first temperature. In one example, high-power first chip 106 operates and generates heat at a temperature ranging from 90°C to 100°C. In other examples, the temperature may be greater than 90°C or greater than 100°C. In still other examples, the temperature may be greater than 70°C. In another example, second chips 114a-114f operate and generate heat at a temperature ranging from 50°C to 70°C. In other examples, second chips 114a-114f operates and generates heat at a temperature less than 70°C, or less than 60°C, or less than 50°C.

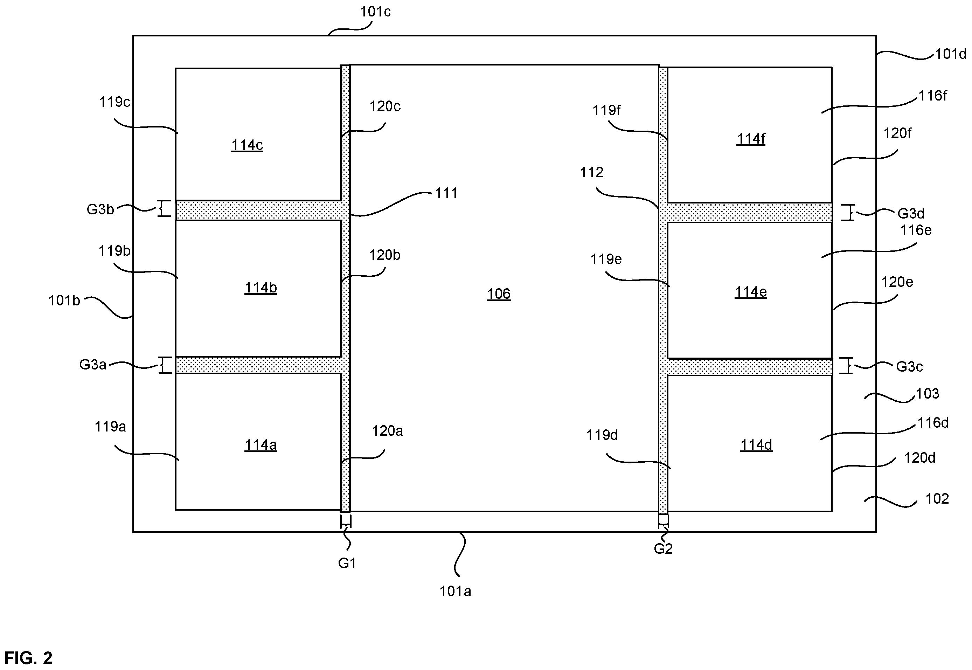

Example chip package 100 may include a substrate 102 having a top surface 103, a bottom surface 104, and edge surfaces 101b, 101d extending between top and bottom surfaces 103, 104. As shown in FIG. 2, edge surfaces of substrate 102 include first front edge 101a, first side edge 101b, second rear edge 101c, and second side edge 101d. First chip 106, which in this example is a high-power chip may have a front edge 109 adjacent front edge 101a of substrate 102, a rear edge 113 adjacent rear edge 101c of substrate 102. First chip 106 may also be positioned be directly adjacent second chips 114a-114f, which in this example are low-power chips. With reference back to FIG. 1, each of chips 106 and 114a-114f may be coupled to top surface 103 of substrate 102. First chip 106 may have an active front surface 110 that faces toward top surface 103 of substrate 102. Active front surface 118a of second chip 114a faces toward top surface 103 of substrate 102 and active front surface 118d of second chip 114d faces toward top surface 103 of substrate 102. In this example, chips 106 and 114a-114f are bonded directly to top surface 103 of substrate 102 using solder ball connections 142. Other forms of interconnection can be implemented, such as pins, posts, or the like. In other examples, one or more of chips 106, 114a-114f may be indirectly bonded to board 102, such as through the use of an interposer, or multiple chips may be stacked one on top of the other and interconnected with conductive vias.

In one example, high-power chip 106 may be positioned at a central portion of device package 100 along a neutral axis 105. In this example, neutral axis 105 is a central axis that extends in a direction perpendicular to a major surface of substrate 102, such as top surface 103 or bottom surface 104 of substrate 102. Low-power chips 114a-114f may be positioned adjacent high-power chip 106 and positioned further away from the neutral axis. High-power chips consume power at a high rate and generate significant heat. Examples of high-power chips can include, without limitation, a server central processing unit ("CPU") chip, an application-specific integrated circuit ("ASIC") chip, graphic processing unit ("GPU"), or tensor processing unit ("TPU"), all of which consume significant power and generate significant heat. Low-power chips typically consume power at low rates, such that the low-power chip does not generate high levels of heat. Examples of low-power chips may include, without limitation, memory chips, such as a high bandwidth memory ("HBM") chip. Thermal cooling device 150 may overlie and extend around HTIM 122, high-power chip 106, and low-power chips 114a-114f. Thermal cooling device 150 may include a major surface or top surface 152 that extends in a direction parallel to board 102, as well as an interior surface 153. Thermal cooling device 150 may include lateral supports 154 with end surfaces 155 bonded to board 102. Lateral supports 154 may be bonded to board 102 using a bonding material 156, which can include an adhesive material, a TIM, or the like. Lateral supports 154 may also function as a stiffener to further minimize warping of board 102 and the overall chip package 100. As shown, interior surface 153 of thermal cooling device 150 may be bonded to top surface 134a of second TIM 132a, top surface 126 of first TIM 124, and top surface 134b of second TIM 132b. In other examples, thermal cooling device 150 can instead or additionally comprise a liquid cooling device or other forms of cooling mechanisms that can be coupled to the IC chips in the package to allow for heat distribution and/or dissipation of heat generated by IC chips in the package assembly.

FIG. 2 illustrates an example arrangement of IC chips bonded to substrate 102 without the other components in chip package device 100 for ease of discussion. First chip 106 may be bonded to a central portion of substrate 102. In this example, first chip 106 extends across top surface 103 of substrate 102 between a front edge 101a and rear edge 101c of substrate 102. Second chips 114a, 114b, 114c, 114d, 114e, 114f (collectively "low-power chips 114a-114f"), which in this example are low-power chips, are shown positioned adjacent first chip 106. In this example, three of the second chips 114a, 114b, 114c have respective side edges 120a, 120b, 120c that are positioned adjacent side edge 111 of first chip 106, as well as opposed and respective side edges 119a, 119b, 119c that are adjacent side edge 101b of substrate 102. Rear surfaces 116a, 116b, 116c of respective second chips 114a, 114b, 114c are also shown in this view. Three second chips 114d, 114e, 114f have respective side edges 119d, 119e, 119f that are positioned adjacent side edge 112 of first chip 106, as well as side edges 120d, 120e, 120f that are adjacent side edge 101d of substrate 102. Rear surfaces 116d, 116e, 116f of respective chips 114d, 114e, 114f are also visible in this view.

In this example, as shown in FIGS. 1-2, a first gap G1 is formed in a space between side edge 111 of first chip 106 and side edges 120a-120c of second chips 114a-114c. Similarly, a second gap G2 may be formed in a space between side edge 112 of first chip 106 and side edges 119d-119f of second chips 114d-114f. Gap G3a is formed between edge 114a-1 of chip 114a and edge 114b-1 of chip 114b. Gap G3b is formed between edge 114b-1 of chip 114b and edge 114c-1 of chip 114c. Gap G3c is formed in the space between edge 114d-1 of chip 114d and edge 114e-1 of chip 114e. Gap G3d is formed in the space between edge 114e-1 of chip 1143 and edge 114f-1 and chip 114f. In some examples, the space between each of the chips may be filled with a fill material. Although not required, the fill material can fill the space between the gaps so that a top surface of the fill material within the respective gaps forms a continuously planar and co-planar surface across and between each of the chips.

FIGS. 1-2 illustrate the presence of fill material 121, which fills the space between gaps G1,G2, G3a-G3d. Fill material 121 can also be used to fill space S between top surface 103 of substrate 102 and bottom surfaces 118a, 110, 118d of first chip 106 and second chips 114a, 114b, as well as all chips in the package assembly. In one example, fill material 121 may be used to fill gaps G1, G2, G3a-G3d and configured to have a top surface 123 that is planar with top surfaces of adjacent chips. As shown in FIG. 1, top surfaces 123 of fill material 121 at gap G1 and gap G2 are planar. This allows for top surfaces 123 of fill material 121 at gap G1 and gap G2 to be coplanar with top surfaces 116a, 108, 116d of respective adjacent chips 114a, 106, 114d, as well as top surfaces of fill material 121 in gaps G3a-G3d to be coplanar with remaining chips in the package. This provides for a continuously planar surface across all chips in the package, which in some examples, will aid in the application of HTIM. In other examples, top surfaces of fill material 121 are not coplanar with top surfaces of chips. For example, a specific application may favor a non-coplanar top surface of the fill material and adjacent chips. Similarly, the type of fill material, such as an underfill, may not possess the properties to form a planar top surface that is coplanar with chips in the system.

In one example, fill material 121 may be a mold material, including without limitation, an epoxy mold compound, a high silicon content epoxy material, or any other mold material. In other examples, fill material 121 may be an underfill material including, without limitation, a liquid polymer, liquid epoxy, or any other type of underfill material. In some examples where fill material 121 is an underfill material, such fill material forms a nonplanar surface. As shown, fill material 121 may also be used to fill space S between substrate 102 and bottom surface 110 of first chip 106, bottom surface 118a of second chip 114a and bottom surface 118d of second chip 114d, as well as bottom surfaces of the remaining chips in the package. In other examples, a fill material used to fill space S may be different than the fill material 121 used to fill the gaps between chips in the package assembly. The gaps and space S may be filled with fill material using known methods and in any order. For example, gaps between the chips may be filled with fill material 121 at a same time or a different time than fill material 121 or other fill material used to fill space S.

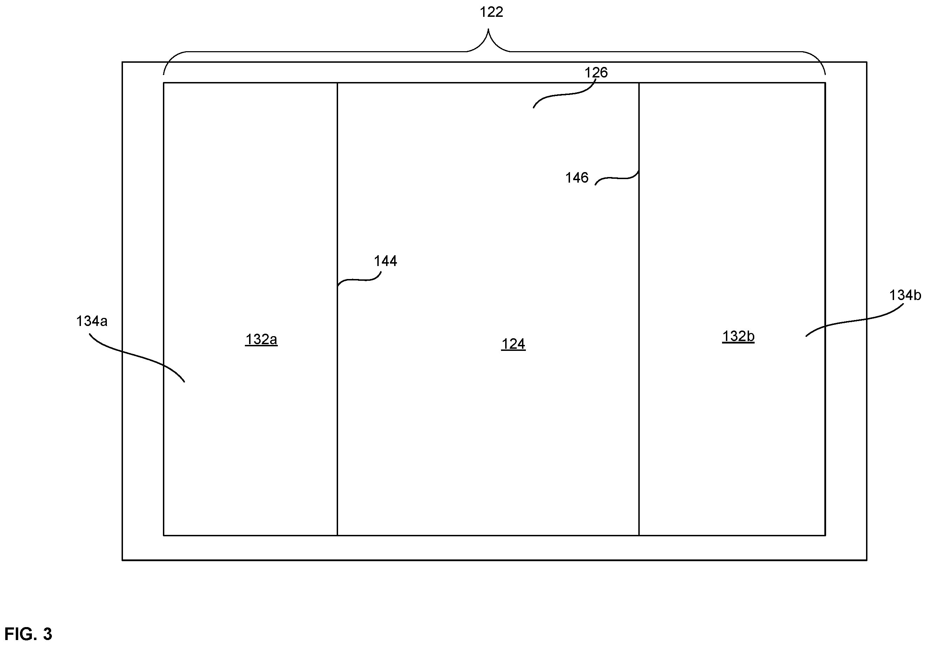

HTIM 122 may be formed from two or more different TIMs. With reference to FIGS. 1 and 3, in one example, HTIM 122 may be comprised of at least two different TIMs: first TIM 124 and second TIM 132, which in this example includes second TIMs 132a and 132b. As discussed herein, in some examples, the second TIM includes second TIM 132a and second TIM 132b, such that first TIM 132a and second TIM 132b will be collectively referred to as second TIM 132. In such examples, second TIM 132a and second TIM 132b are comprised of substantially the same material. In other examples, second TIM 132b may be comprised of a different material than TIM 132a, such that second TIM 132b can be considered a third TIM. As shown in FIG. 1 and FIG. 3, which shows HTIM 122 overlying chips 114a-114d and 106 shown in FIG. 2, first TIM 124 is positioned between second TIM 132a and second TIM 132b. Bottom surface 128 of first TIM 124 may overlie rear surface 108 of first chip 106 and in some examples may be bonded to rear surface of first chip 106. Bottom surface 136a of second TIM 132a overlies and is bonded to rear surface 116a of second chip 114a. Similarly, bottom surface 136b of second TIM 132b overlies rear surface 116d of second chip 114d. In some examples, second TIM 132b is bonded to rear surface 116d of second chip 114d.

First TIM 124 and second TIM 132 may diffuse and/or be joined together to form HTIM 122. In some examples, first TIM 124 and second TIM 132 be positioned adjacent to one another such that the first TIM 124 and second TIM 132 retain their individual properties. In one example, first TIM 124 and second TIM 132 may be positioned adjacent to one another and contact one another, such that, for example, first and second TIMs 124, 132 retain their individual properties. In such examples, first TIM and second TIM 132 may, for example, abut one another or be directly adjacent one another. Common edge 144 may be formed where first TIM and second TIM 132 meet and contact one another. In other examples, first and second TIMS 124,132 may diffuse together such that the properties of the first and/or second TIMs 124, 132 become modified. For example, first TIM 124 and second TIM 132a may diffuse along a first common edge 144 where first TIM 124 and second TIM 132a meet or make contact with one another. First TIM 124 and second TIM 132b may similarly diffuse or be reflowed and cure along a second common edge 146. In other examples, where first TIM 124 includes a metal material and reflows during processing, first TIM 124 and second TIMs 132a, 132b may also be soldered together. In still other examples, there may be diffusion soldering between first TIM 124 and second TIMs 132a, 132b, in which there is both diffusion bonding and soldering along the common boundary or edge. In still other examples, first TIM 124 and second TIMs 132a, 132b may be joined together as a heterogenous unit using other forms of joinder.

In other examples, first TIM 124 and second TIM 132 may be spaced apart from one another. For example, first TIM 124 and second TIM 132 may have distinct boundaries that align with a respective peripheral edge of the underlying chip. Similarly, first TIM 124 and second TIM 132 may extend beyond respective peripheral edges of underlying chips, but not contact one another. In such examples, a gap or space may exist between first TIM 124 and second TIM 132, such that first TIM and second TIM do not contact one another.

Although first and second common edges 144, 146 are shown as a straight line, it is to be appreciated that common edges 144, 146 may not occur in straight lines, but may vary based on the various properties of first TIM 124 and second TIM 132a,132b. As noted above, it is not required for first TIM 124 and second TIM 132 to diffuse together and in some examples, they may be positioned directly adjacent to one another without diffusing together. In examples where it is desired for first TIM 124 and second TIM 124, 132 to diffuse together, diffusion can occur during assembly of chip package 100. For example, first TIM 124 and second TIM 132 may be heated to a temperature sufficient to create diffusion between the materials forming first TIM 124 and second TIM 132. Typical processing of chip package 100, first TIM 124 and second TIM 132 may be subject to temperatures reaching, for example without limitation, up to 100°C. In examples where it is desired to diffuse first TIM 124 and second TIM 132 together, first and second TIMS 124, 132 may be subject to reflow temperatures ranging from 130°C to 200°C, and in other examples subject to reflow temperatures ranging from 130°C to 240°C. In some examples, reflow temperatures may be greater than 120°C, or greater than 150°C, or greater than 200°C or greater than 240°C. For example, solder diffusion of first and second TIMs 124, 132 may occur at temperatures ranging from approximately 180°C-240°C. But, in other examples, the temperature may be greater than 240°C or less than 180°C. In some examples, heating of chip package 100 can occur once thermal cooling device 150 is positioned to overlie chips 106 and 114a-114f in chip package assembly 100 and thermal cooling device 150 is pressed onto substrate 102 and rear surfaces 108, 116a-116f of chips 106, 114a-114f, respectively.

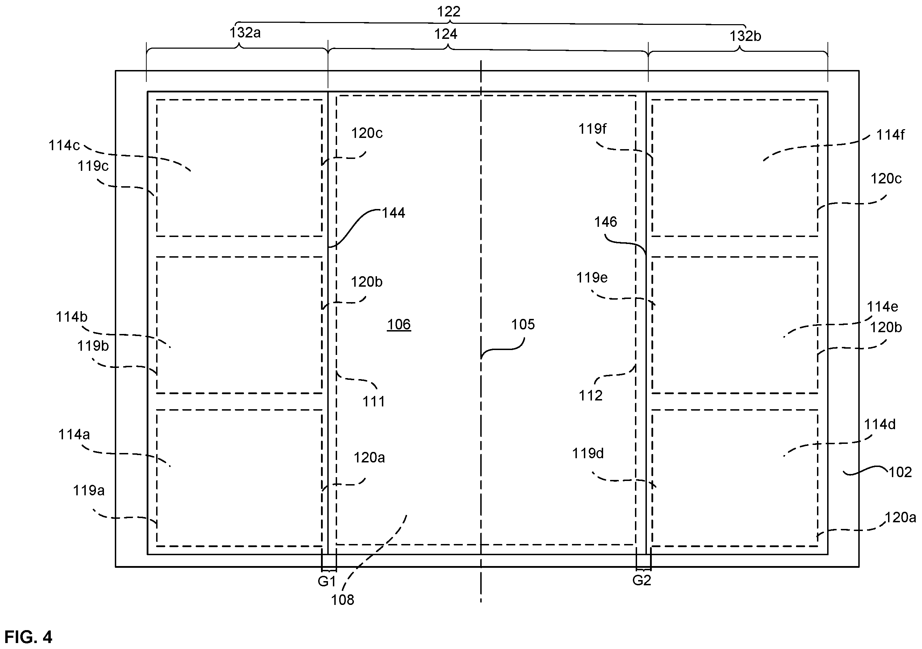

With reference to FIG. 4, which illustrates first chip 106 and second chips 114a-114f and overlying HTIM 122 (here comprised of first TIM 124 and second TIM 132), without overlying thermal cooling device 150. As shown, first TIM 124 may overlie and be deposited over first chip 106, which in this example is a high-power chip that generates significant heat. First TIM 124 may be directly deposited on first chip 106 and cover a majority of a major surface of first chip 106, which includes active front surface 110 or passive rear surface 108 of first chip 106. In this example, first TIM 124 may be deposited over an entire rear surface 108 of first chip 106.

First TIM 124 may be comprised of a material possessing a high thermal conductivity and a low modulus of elasticity. This is because first chip 106 is positioned along neutral axis 105, where warping of chip package 100, including substrate 102 and first chip 106, will be minimal. Furthermore, in examples where first chip 106 is a high-power chip that consumes high power and generates significant heat, selection of a TIM with a high thermal conductivity can help to effectively transfer heat from first chip 106 to a thermal cooling device 150, such as a heat sink. The material comprising first TIM 124 can be selected from a group of materials that can diffuse or reflow during processing of chip package 100.

A TIM comprising a metal may be selected for first TIM 124. This allows for use of a TIM that has a high thermal conductivity and that may be more rigid when cured, but becomes less rigid and more fluid when heated. Examples of a metal-based TIM can include a TIM having a thermal conductivity ranging from 40 W/(m·K) to 110 W/(m·K), and in some examples 50 W/(m·K) to 100 W/(m·K). In other examples, thermal conductivity may be less than 50 W/(m·K) or more than 30 W/(m·K). A solder metal thermal interface material ("STIM") is one example of a TIM that can be selected for first TIM 124. A STIM which possesses high thermal conductivity, for example without limitation, a solid solder, such as an indium or indium alloy solder can be utilized. In some examples, first TIM 124 is disposed across a majority of rear surface 108 of first chip 106. In this example, first TIM 124 is disposed across the entire rear surface 108 of first chip 106, including being disposed across portions of rear surface 108 adjacent a peripheral edge of first chip 106. Due to its properties, a first TIM 124 that may reflow during operation of the chip package device can be implemented. When first TIM 124 includes a metal, such as a STIM, and only overlies first chip 106, reflow of first TIM 124 can cause short circuiting of other chips in chip package 100.

A second TIM 132 possessing characteristics and features different from first TIM 124 may overlie a second chip 114 that generates less heat than first chip 106 and that is positioned further away from neutral axis 105. In this example, second TIM 132 may overlie second chips 114 that produce less heat than the first chip 106, which in this example is a high-power chip. Second TIM 132 may overlie a majority of a major surface of the lower-power chips. In this example, second TIM 132 overlies rear surfaces of second chips 114a-114f . As shown, second TIM 132a overlies second chips 114a-114c and second TIM 132b overlies second chips 114d-114f. Second TIMs 132a, 132b may overlie the majority of the rear surfaces of chips 114a-114f, and in this example, second TIMs 132a, 132b overlie substantially an entire rear surface 116a-116f of each chip 114a-114f. In this configuration, second TIM 132a is positioned adjacent to one side of first TIM 124 and second TIM 132b is positioned adjacent the opposed side of first TIM 124.

The composition of second TIM 132 can be selected based on its modulus of elasticity; second TIM 132 preferably possesses a high modulus of elasticity. In some examples, material comprising second TIM 132 can include a polymer having a high modulus of elasticity. Such polymers can have low thermal conductivity, such as, without limitation, in the range of 3 W/(m·K) to 10 W/(m·K). A polymer-based second TIM 132 can additionally be selected based on its ability to compensate for warping of second chips 114a-114f and/or the portion of substrate underlying second chips 114a-114f during use of chip package 100. Additionally, since second chips 114a-114f, which in this example are low-power chips, do not generate significant heat under normal operating conditions, the material selected for second TIM 132 does not need to possess high thermal conductivity or possess a thermal conductivity similar to that of first TIM 124.

In some examples, a polymer TIM can include a composite containing organic polymer material and thermally conductive fillers. Thermally conductive fillers can include, without limitation, carbon, metalloids, and polymers. The material(s) comprising second TIM 132 can be selected to prevent reflow of first TIM 124 onto neighboring interconnections of low-power chips and/or interconnections that may be present in chip package assembly and which may short circuit. In this regard, second TIM 132 can be capable of creating a barrier or shield to prevent reflow of first TIM 124 from reaching and short circuiting low-power chips or devices and interconnections adjacent a high-power chip. In other examples, polymers can include combinations, such as a polymer-enhanced oil or grease.

In this example, first TIM 124 may only overlie first chip 106, which in this example is a high-power chip, and second TIM 132 may only overlie second chips 114a-114f, which in this example may be low-power chips. In other examples, first TIM 124 may overlie only a portion of first chip 106 and second TIM 132 may overlie both first chip 106 and second chips 114a-114f.

Common edge 144 between first TIM 124 and second TIM 132a and common edge 146 between first TIM 124 and second TIM 132b can be positioned at various positions. In an example where first TIM 124 covers an entire rear surface 108 of first chip 106 and second TIM 132 covers entire rear surfaces 116a-116f of second chips 114a-114f, a common edge 144 may be positioned in gap G1 between side edge 111 of first chip 106 and side edges 120a-120c of second chips 114a-114c. Common edge 146 may be similarly positioned in gap G2 positioned between second side edge 112 of first chip 106 and side edges 119d-119f of second chips 114d-114f. In examples where fill material 121 fills gaps G1, G2, common edge 146 will overlie fill material 121.

HTIM 122 collectively thermally couples thermal cooling device 150 to each of chips 106 and 114a-114f in chip package 100. In some examples, HTIM 122 may further bond thermal cooling device 150 to each of chips 106 and 114a-114f in chip package 100. In this example, as shown in FIG. 1, first TIM 124 can be used to bond first chip 106 to thermal cooling device 150. Second TIM 132 bonds thermal cooling device 150 to each of second chips 114a-114f. In particular, second TIM 132a bonds second chips 114a-114c to thermal cooling device 150 and second TIM 132b bonds second chips 114d-114f to thermal cooling device 150. This arrangement allows for improved cooling of first chip 106, which in this example is a high-power chip that operates at a high temperature and generates significant heat. Selection of first TIM 124, which in this example may be a STIM, allows for improved heat transfer from first chip 106 to thermal cooling device 150. Since first chip 106 is positioned along neutral axis 105, there is less potential for warpage at first chip 106 and the portion of substrate 102 underlying first chip 106. Similarly, second TIM 132, which can be selected based on its modulus of elasticity, can provide for warpage control of chip package 100, including chips 106, 114a-114f and substrate 102.

Use of HTIM 122 according to aspects of the disclosure can allow for use of a heterogenous TIM used across multiple chips. A first TIM 124 of HTIM 122 may overlie a high-power chip or a chip operating at high temperatures and that has a high thermal conductivity, as discussed above, to be utilized over an entire surface or a majority of the surface of first chip 106. Use of a second TIM 132 of HTIM 122 comprised of a polymer material can be implemented to prevent reflow of first TIM 124 onto low-power second chips 114 and/or components adjacent first TIM 124 or high-power chip 106 that may cause short circuiting. This arrangement of materials comprising HTIM 122 can allow for improved adhesion properties and resistance to thermal cycling due to effective transfer of heat from high-power chip 106 to thermal cooling device 150. Additionally, mechanical stability is enhanced to minimize warpage of the overall chip package device.

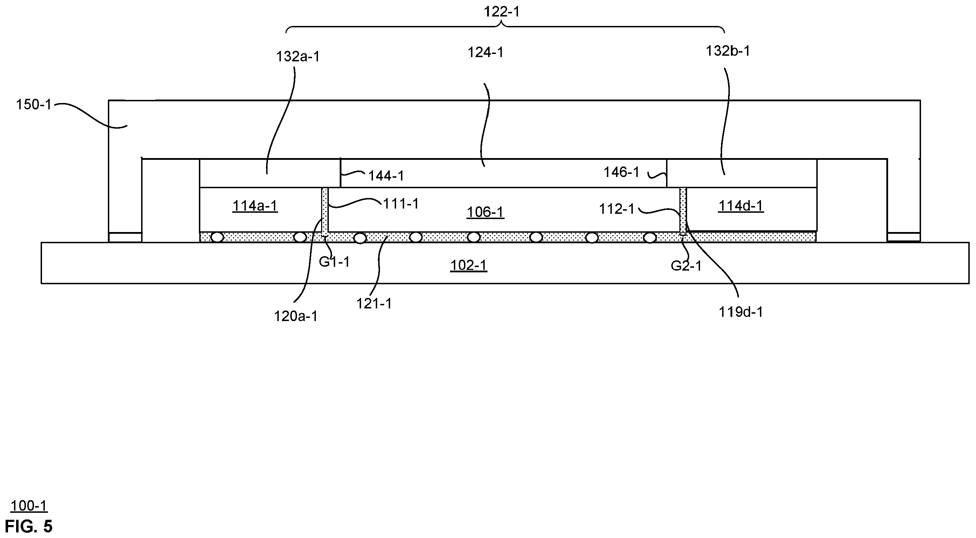

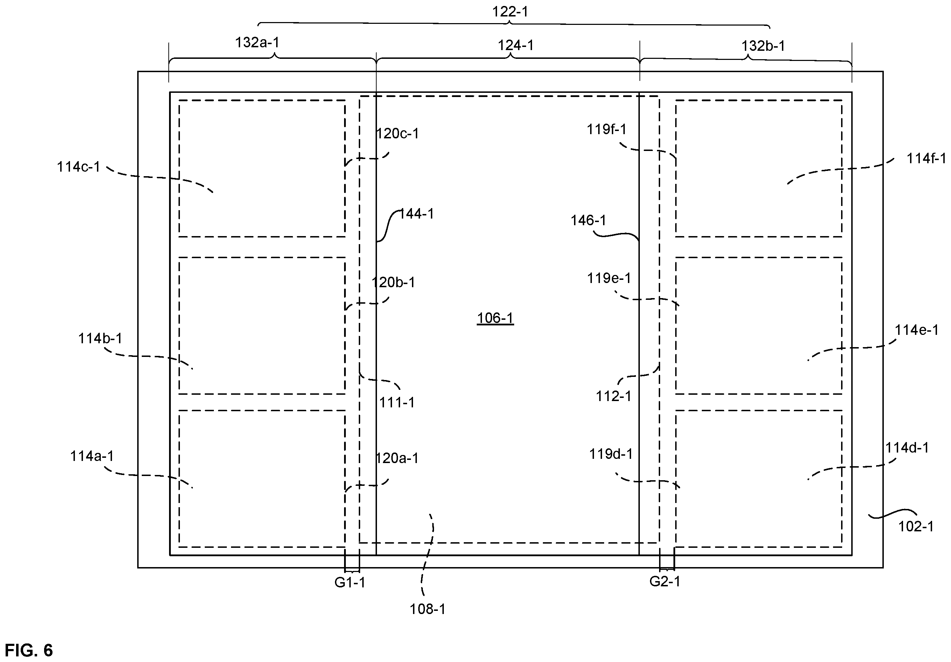

FIG. 5 illustrates a schematic cross-sectional view showing an alternative configuration for HTIM 122-1 in chip package 100-1. Chip package 100-1 only differs from chip package 100 of FIGS. 1-4 due to the position of common edges 144-1 and 146-1, and is otherwise identical to chip package 100, such that the discussion will focus on the differences for ease of discussion. As shown in FIGS. 5-6, common edge 144-1 does not overlie gap G1-1, which is positioned between edge 111-1 of first chip 106-1 and edges 120a-1 to 120c-1 of respective second chips 114a-1 to 114c-1. Similarly, common edge 146-1 does not overlie gap G2-1, which is positioned between edge 112-1 of first chip 106-1 and edges 119d-1 to 119f-1 of respective second chips 114d-1 to 114f-1. In this example, first TIM 124-1 only overlies a portion of first chip 106-1. Second TIM 132a-1 is positioned laterally adjacent and to the left of first TIM 124-1. Second TIM 132a-1 overlies both second chips 114a-1 to 114c-1 and a portion of first chip 106-1. As shown, second TIM 132a-1 extends across and overlies edges 120a-1 to 120c-1 of respective second chips 114a-1 to 114c-1, gap G1-1, and edge 111-1 of first chip 106-1. Second TIM 132b-1 is positioned laterally adjacent and to the right of first TIM 124-1. Second TIM 132b-1 similarly overlies second chips 114d-1 to 114f-1 and a portion of first chip 106-1. As shown, second TIM 132b-1 extends across and overlies edges 119d-1 to 119f-1, gap G2-1 and edge 112-1 of first chip 106-1. In this example, first TIM 124-1 overlies a majority of rear surface 108-1 of first chip 106-1, such that first TIM 124-1 is able to transfer heat from first chip 106-1 to thermal cooling device 150-1, while at the same time second TIMs 132a-1, 132b-1 help to balance warping of chip package 100-1, including first chip 106-1 and second chips 114a-1 to 114f-1 that are bonded to substrate 102-1.

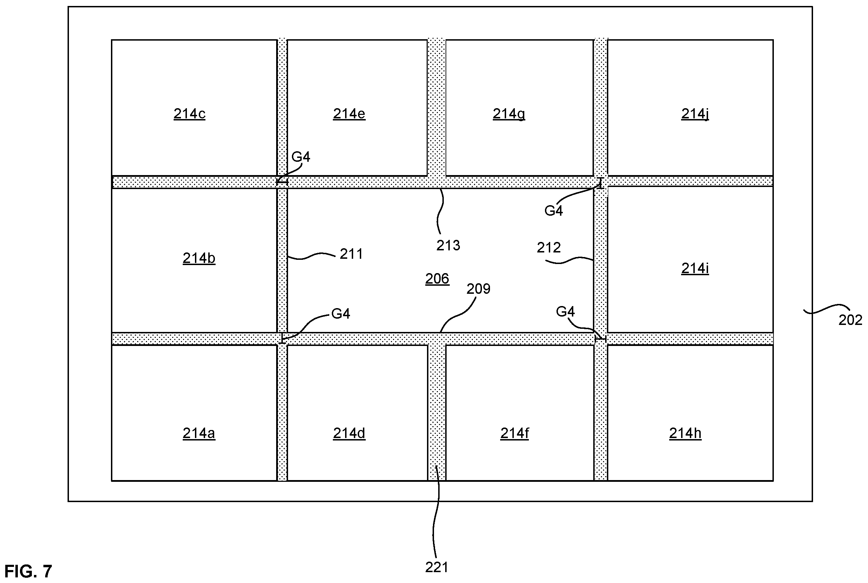

FIGS. 7-9 illustrate another example of an arrangement of chips in a chip package 200 and an example HTIM overlying chips, without illustrating a thermal cooling device for ease of discussion. FIGS. 7-9 illustrate similar components as chip package 100 and the individual components and features will not be described again, so that the discussion focuses on this example arrangement of chips and HTIM. Turning first to FIG. 7, an arrangement of IC chips bonded to substrate 202 is shown. In this example, first chip 206 is positioned at a central portion of substrate 202. As in the previous examples, first chip 206 may generate a significant amount of heat and in some examples, may be a high-power chip that generates high levels of heat at a first temperature, as previously described herein. Second chips 214a-214j may generate heat at a second temperature that is less than the first temperature of first chip 206. In such example, second chips 214a-214j may be low-power chips, such as previously described herein. Gap G4 may extend continuously around first chip 206 and each of chips 214a-214-h. Although gap G4 is shown to have a substantially similar size or width around first chip 206, gap G4 may differ at one or more points around first chip 206. Fill material 221 may be used to fill gap G4, as well as spaces between each of the other chips 214a-214h, as previously described herein. Fill material 221 may include any fill material, such as mold, or an underfill. Although not required, fill material 221 may be configured so that the top surface of fill material 221 is co-planar with top surfaces of the adjacent chips. But, in other examples, the top surface of fill material 221 may be positioned below top surfaces of adjacent chips.

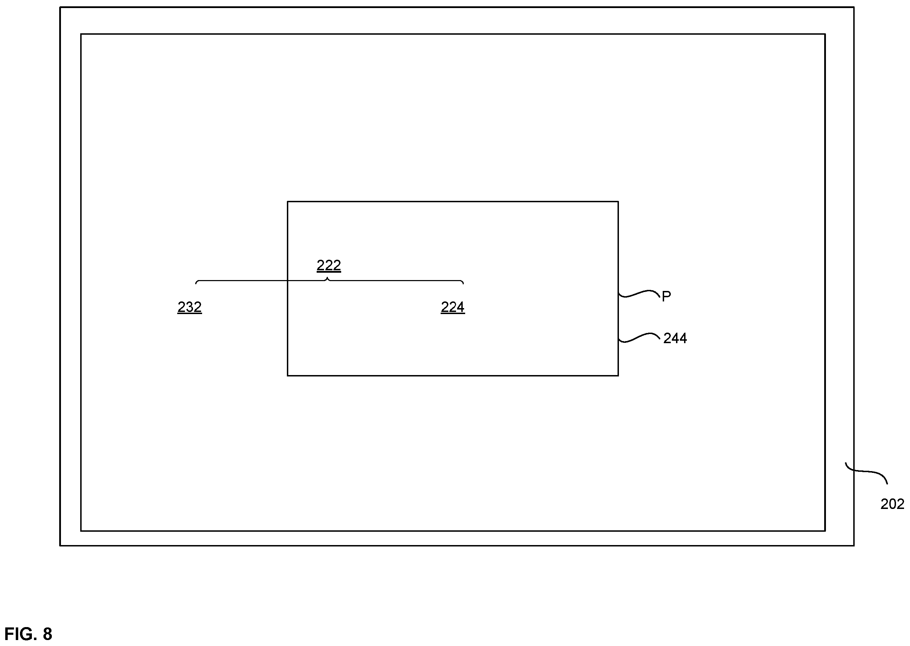

FIGS. 8-9 illustrate an arrangement of HTIM 222 overlying first chip 206 and second chips 214a-214j. FIG. 8 depicts the arrangement of HTIM 222 without illustrating the underlying chips. As shown, HTIM 222 includes first TIM 224 and second TIM 232 that may be diffused and/or reflowed together. In this example, second TIM 232 extends around a periphery P of first TIM 224, which is also a continuous common edge 244 between first TIM 224 and second TIM 232.

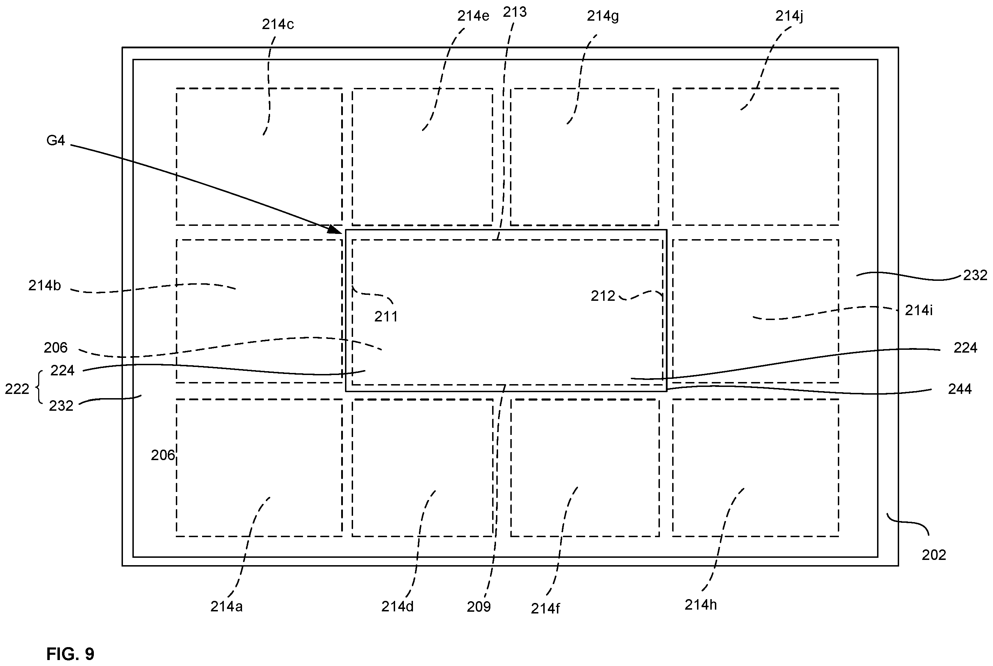

FIG. 9 depicts both HTIM 222 and underlying first chip 206 and second chips 214a-214j. As shown, common edge 244 overlies gap G4, shown in FIG. 7, that extends around first chip 206, as well as fill material 221. Gap G4 extends between first chip 206 and each of second chips 214a-214j. As shown, HTIM 222 extends beyond all four edges of first chip 206 and second chips 214a-214j. First TIM 224 overlies an entire rear surface of first chip 206 and beyond side edges 211, 212, front edge 209 and rear edge 213 of first chip 206. Second TIM 232 overlies and extends across all of second chips 214a-214j, as well as fill material 221. In other examples, common edge 244 may overlie first chip 206 in its entirety, such that second TIM 232 overlies both first chip 206 and all of second chips 214a-214j.

As in the previous arrangement, the configuration of first TIM 224 and second TIM 232 can assist with transfer of heat between first chip 206 and an overlying thermal cooling device, as previously described herein. Use of HTIM 222 according to aspects of the disclosure can allow for use of a heterogenous TIM used across multiple chips. A first TIM 224 of HTIM 222 may overlie a high-power chip 206 or a chip operating at high temperatures and that has a high thermal conductivity, as discussed above, to be utilized over an entire surface or a majority of the surface of the high-power chip. Use of a second TIM 232 of HTIM 222 comprised of a polymer material can be implemented to prevent reflow of first TIM 224 onto low-power chip(s) and/or components adjacent first TIM 224 or high-power chip 206 that may cause short circuiting. This arrangement of materials comprising HTIM 222 can allow for improved adhesion properties and resistance to thermal cycling due to an effective transfer of heat from high-power chip 206 to thermal cooling device 250. Additionally, mechanical stability is enhanced to minimize warpage of overall chip package device.

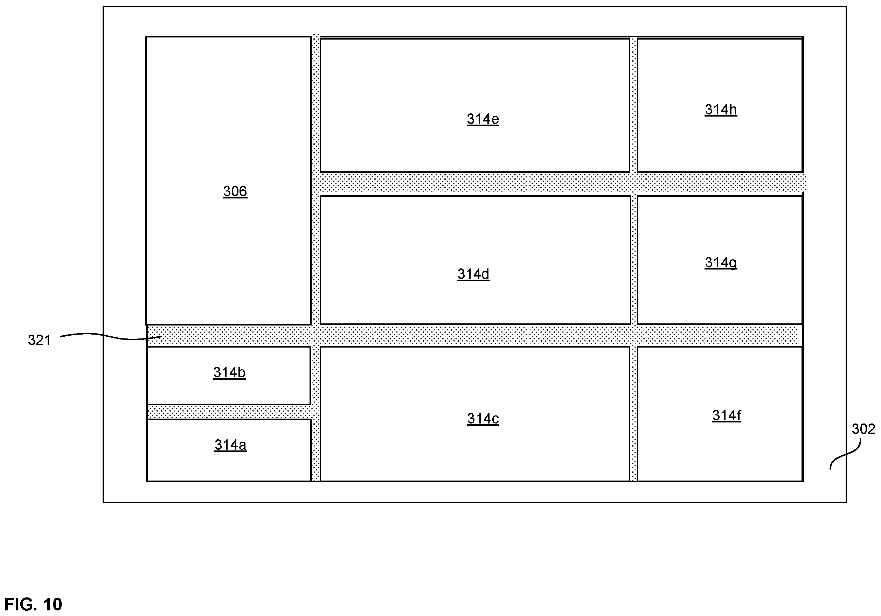

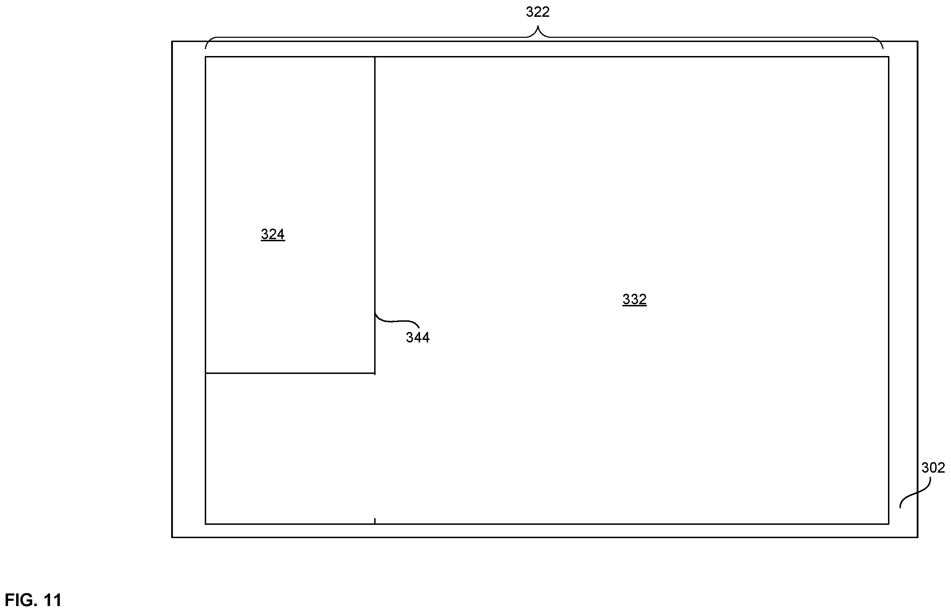

Although in previous examples, a first chip which operates at high temperatures and generates a high amount of heat was positioned at a central portion of a substrate relative to second chips which generate less heat, a first chip may be positioned along other portions of a substrate. For example, as shown in FIG. 10, first chip 306 is positioned at an outermost left corner of substrate 302, which may be a high-power chip generating significant heat. Second chips 314a to 314h may be low-power chips and generate less heat. As shown in FIG. 11, HTIM 322 may include a first TIM 324 overlying first chip 306 and a second TIM 332 overlying remaining chips 314a to 314h. In this example, common edge 344 is formed along two edges of first TIM 324.

It is to be appreciated that numerous other arrangements of chips and overlying HTIM may be implemented and need not be described herein. For example, and without limitation, there may be chips that generate different amounts of heat that are stacked vertically one on top of the other and the HTIM may be positioned between one or more stacked chips. In such examples, the first TIM and second TIM may be vertically aligned with one another and contact one another. Similarly, in examples where first and second TIM have distinct edges, second TIM may extend partially or fully around first TIM such that second TIM extend around one, two, three, or four edges of the first TIM. Further, although edges of first TIM and second TIM are illustrated as having straight edges, it is to be appreciated that one or more edges of either the TIM and second TIM may instead have a different shape. For example, in examples where first TIM and second TIM may have rounded edges and contact one another, a common edge between first TIM and second TIM may be in the shape of a circle.

According to an aspect of the disclosure, an integrated circuit ("IC") chip package assembly includes a substrate; a first IC chip; a second IC chip; a thermal cooling device; and a heterogeneous thermal interface material ("HTIM"). The first IC chip may be coupled to the substrate and generate heat at a first temperature. A second IC chip directly adjacent the first IC chip is coupled to the substrate. The second IC chip generates heat at a second temperature that is less than the first temperature. The thermal cooling device overlies the first IC chip and the second IC chip. The HTIM includes a first thermal interface material ("TIM") and a second TIM. The first TIM and the second TIM are joined together. The first TIM overlies the first IC chip and the second TIM overlies the second IC chip. The HTIM bonds the first and second IC chips to the thermal cooling device. The first TIM may comprise a material having a first thermal conductivity and a first modulus of elasticity. The first TIM reflows when the first TIM reaches a first TIM reflow temperature. The second TIM may include at least a polymer material. The second TIM has a second modulus of elasticity that is greater than the first modulus of elasticity and a second thermal conductivity that is less than the first thermal conductivity; and/or
the first TIM and the second TIM are diffusion soldered together; and/or
the first chip is a high-power chip and the second chip is a low-power chip; and/or
the first TIM comprises a solder TIM ("STIM"); and/or
the second TIM provides a boundary to inhibit reflowed first TIM from flowing onto a component adjacent the first IC chip; and/or
the second TIM is mechanically more tolerant than the first TIM so as to be able to absorb thermal shocks imposed by silicon dynamic warpage; and/or
the assembly further includes a third IC chip, wherein the second IC chip and the third IC chip are positioned on opposite sides of the first IC chip, and the second TIM is also applied to the third chip; and/or
the thermal cooling device includes a heatsink, and the first TIM conducts heat from the high-power chip to the heat sink; and/or
the thermal cooling device further comprises a liquid cooling device coupled to the heatsink; and/or
the first TIM extends across a portion of a rear surface of the first IC chip; and/or
the first TIM extends across a majority of the rear surface of the first IC chip and the second TIM extends across at least a portion of the rear surface of the first IC chip; and/or
the first TIM extends across an entire rear surface of the first IC chip and the second TIM only extends across an entire rear surface of the second IC chip; and/or
the first IC chip is positioned along a neutral axis that extends vertically through a central portion of the substrate and the second IC chip is spaced further away from the neutral axis than the first IC chip; and/or
the first thermal conductivity is greater than 50 W/(m·K); and/or
the first IC chip operates at a temperature ranging from 90°C to 100°C; and/or
the low-power chip operates at a temperature ranging from 50°C to 70°C; and/or
the second IC chip is a plurality of second IC chips, at least some of the plurality of second IC chips being positioned adjacent the first IC chip; and/or
the second TIM comprises a composite material of organic polymer material(s) and thermally conductive fillers; and/or
the second TIM extends around at least a portion of the first TIM; and/or
the second TIM extends around an entire periphery of the first TIM; and/or
the common edge is in the shape of a square; and/or
the common edge is in the shape of a circle.

According to another aspect of the disclosure, an integrated circuit ("IC") chip package assembly includes a substrate; a first IC chip coupled to the substrate and generating heat at a first temperature; a second IC chip; a thermal cooling device; and a heterogeneous thermal interface material ("HTIM"). The second IC chip may be directly adjacent the first IC chip and coupled to the substrate. The second IC chip may generate heat at a second temperature that is less than the first temperature. The thermal cooling device may overlie the first IC chip and the second IC chip. The HTIM includes a first thermal interface material ("TIM") and a second TIM. The first TIM and the second TIM are joined together. The first TIM overlies the first IC chip and the second TIM overlies the second IC chip. The HTIM bonds the first and second IC chips to the thermal cooling device. The first TIM may include a material having a first thermal conductivity and a first modulus of elasticity. The first TIM may diffuse with the second TIM when the second TIM reaches a first diffusion temperature. The second TIM may include at least a polymer material. The second TIM may have a second modulus of elasticity that is greater than the first modulus of elasticity and a second thermal conductivity that is less than the first thermal conductivity; and/or
the first TIM comprises a TIM having a metallic component; and/or
the first TIM and second TIM are diffusion soldered together; and/or
the first TIM is a solder TIM ("STIM"); and/or
the second TIM provides a boundary to inhibit reflowed first TIM from flowing onto a component adjacent the first IC chip; and/or
the second TIM is mechanically more tolerant than the first TIM so as to be able to absorb thermal shocks imposed by silicon dynamic warpage; and/or
a third IC chip, wherein the second IC chip and the third IC chip are positioned on opposite sides of the first IC chip, and the second TIM is also applied to the third IC chip; and/or
the second TIM extends around at least a portion of the first TIM; and/or
the second TIM extends around an entire periphery of the first TIM; and/or
the common edge is in the shape of a square; and/or
the common edge is circular.

According to an aspect of the disclosure, an integrated circuit ("IC") chip package assembly comprises a substrate, a first IC chip, a second IC chip, a fill material, a thermal cooling device, and heterogeneous thermal interface material ("HTIM"). The first IC chip is coupled to the substrate and generates heat at a first temperature. The second IC chip is spaced apart from and positioned directly adjacent the first IC chip. The second IC chip generates heat at a second temperature less than the first temperature. The fill material is disposed in a gap between the first IC chip and the second IC chip. The thermal cooling device overlies the first IC chip and the second IC chip. The HTIM further comprises a first thermal interface material ("TIM") and a second TIM. The first TIM and the second TIM are positioned adjacent one another such that they form a common edge. The first TIM overlies the first IC chip and the second TIM overlies the second IC chip. The HTIM bonds the first and second IC chips to the thermal cooling device. The first TIM comprises a material having a first thermal conductivity and a first modulus of elasticity. The first TIM reflows when the first TIM reaches a first TIM reflow temperature. The second TIM comprises at least a polymer material, the second TIM having a second modulus of elasticity greater than the first modulus of elasticity and a second thermal conductivity less than the first thermal conductivity; and/or
the first IC chip is a high-power chip and the second IC chip is a laterally adjacent low-power chip; and/or
a top surfaces of the first IC chip, a top surface of the second IC chip, and a top surface of the fill material are substantially coplanar, such that the top surfaces of the first IC chip, the second IC chip and the fill material are substantially coplanar and form a TIM deposition surface. The first TIM and the second TIM overlie the TIM deposition surface; and/or
the common edge overlies the fill material; and/or
the common edge overlies one of the first or second IC chips; and/or
at least one of the first TIM or the second TIM extends beyond a first outer peripheral edge of the first IC chip or a second outer peripheral edge of the second IC chip; and/or
the at least one of the first TIM or the second TIM extends beyond both the first and second outer peripheral edges; and/or
an outermost edge of the second TIM creates a boundary to inhibit reflowed first TIM from flowing onto a component adjacent the first IC chip; and/or
an outermost edge of the second TIM creates a boundary to inhibit reflowed first TIM from flowing onto a component adjacent the first IC chip; and/or
a material comprising the second TIM enables the second TIM to withstand a greater range of a variation in mechanical properties than the material comprising the first TIM, the second TIM being capable of absorbing thermal shocks imposed by silicon dynamic warpage; and/or
the package further comprises a third IC chip generating heat at a third temperature less than the first temperature. The second IC chip and the third IC chip are positioned on opposite sides of the first IC chip. The second TIM is also applied to the third IC chip; and/or
the thermal cooling device comprises a heatsink, and the first TIM conducts heat from the first IC chip to the heat sink; and/or
the thermal cooling device further comprises a liquid cooling device coupled to the heatsink; and/or
the first TIM extends across a portion of a rear surface of the first IC chip; and/or
the first TIM extends across a majority of the rear surface of the first IC chip and the second TIM extends across at least a portion of the rear surface of the first IC chip; and/or
the first TIM extends across an entire rear surface of the first IC chip and the second TIM extends across an entire rear surface of the second IC chip; and/or
the first IC chip is positioned along a neutral axis extending vertically through a central portion of the substrate and the second IC chip is spaced further away from the neutral axis than the first IC chip; and/or
the first thermal conductivity is greater than 50 W/(m·K); and/or
the first IC chip generates heat at a temperature ranging from at least 90°C to 100°C; and/or
the high-power chip generates heat at a temperature of at least 80°C; and/or
the low-power chip generates heat at a temperature ranging from 50°C to 70°C; and/or
the low-power chip generates heat at a temperature less than the temperature generated by the first IC chip; and/or
the first TIM is comprised of a material having a metallic component, and wherein the first TIM and the second TIM diffuse along the common edge; and/or
the first TIM comprises a solder TIM ("STIM"), and the first TIM and the second TIM are diffusion soldered along the common edge; and/or
the second TIM comprises a composite material of organic polymer material(s) and thermally conductive fillers; and/or
the second IC chip is a plurality of second IC chips, wherein each of the plurality of second IC chips is positioned adjacent the first IC chip; and/or
the second TIM extends around at least a portion of the first TIM; and/or
the second TIM extends around an entire periphery of the first TIM; and/or
the common edge is in the shape of a square; and/or
the common edge is in the shape of a circle; and/or
the fill material comprises one of a mold material or an underfill material.

According to another aspect of the disclosure, an integrated circuit ("IC") chip package assembly comprises a substrate, a first high-power logic chip, a plurality of second low-power memory chips, a fill material, and a heterogeneous thermal interface material ("HTIM"). The first high-power logic chip coupled to the substrate and generating heat at a first temperature. The plurality of second low-power memory chips spaced apart from and positioned adjacent the first IC chip along a same plane, the plurality of second IC chips each generating heat at a second temperature less than the first temperature. The fill material is disposed in gaps between the high-power logic chip and the plurality of second low power memory chips, such that a top surface of the fill material is coplanar with the top surface of the first high-power logic chip and the top surfaces of the plurality of second low-power memory chips. The HTIM comprises a first thermal interface material ("TIM") and a second TIM. The first TIM and the second TIM are positioned adjacent one another such that they form a common edge. The first TIM overlies the first IC chip and the second TIM overlies the plurality of second low-power memory chips. The first TIM comprises a material having a first thermal conductivity and a first modulus of elasticity. The first TIM reflows when the first TIM reaches a first TIM reflow temperature. The second TIM comprises at least a polymer material. The second TIM has a second modulus of elasticity greater than the first modulus of elasticity and a second thermal conductivity less than the first thermal conductivity; and/or
the package further comprises a thermal cooling device overlying the first IC chip and the plurality of second IC chips; and/or
the fill material comprises one of a mold material or an underfill; and/or
the first TIM and the second TIM diffuse along the common edge; and/or
the first TIM and the second TIM contact one another and retain their individual properties; and/or
the first TIM and the second TIM contact one another and are diffusion bonded together along the common edge; and/or
the first TIM comprises a solder TIM ("STIM"), and the first TIM and the second TIM are diffusion soldered along the common edge; and/or
the second TIM extends around at least a portion of the first TIM; and/or
the second TIM extends around an entire periphery of the first TIM; and/or
the common edge is in the shape of a square; and/or
the common edge is in the shape of a circle.

According to another aspect of the disclosure, an integrated circuit ("IC") chip package assembly comprises a substrate, a first high-power logic chip, a plurality of second low-power memory chips, a fill material, and a heterogeneous thermal interface material ("HTIM"). The first high-power logic chip coupled to the substrate and generating heat at a first temperature. The plurality of second low-power memory chips are spaced apart from and positioned laterally adjacent the first IC chip along a same plane, the plurality of second IC chips each generating heat at a second temperature less than the first temperature. The fill material is disposed in gaps between the high-power logic chip and the plurality of second low power memory chips, such that a top surface of the fill material is below the top surface of the first high-power logic chip and the top surfaces of the plurality of second low-power memory chips. The HTIM comprises a first thermal interface material ("TIM") and a second TIM. The first TIM overlies the first IC chip and the second TIM overlies the plurality of second low-power memory chips. The first TIM comprises a material having a first thermal conductivity and a first modulus of elasticity. The first TIM reflows when the first TIM reaches a first TIM reflow temperature. The second TIM comprises at least a polymer material. The second TIM has a second modulus of elasticity greater than the first modulus of elasticity and a second thermal conductivity less than the first thermal conductivity; and/or
the package further comprises a thermal cooling device overlying the first IC chip and the plurality of second IC chips; and/or
the fill material comprises one of a mold material or an underfill.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims. In addition, the provision of the examples described herein, as well as clauses phrased as "such as," "including," and the like, should not be interpreted as limiting the subject matter of the claims to the specific examples; rather, the examples are intended to illustrate only one of many possible implementations. Further, the same or similar reference numbers in different drawings can identify the same or similar elements.

## Claims

1. An integrated circuit, IC, chip package assembly comprising:
a substrate;
a first IC chip coupled to the substrate and generating heat at a first temperature;
a second IC chip spaced apart from and positioned directly adjacent the first IC chip, the second IC chip generating heat at a second temperature less than the first temperature;
a fill material disposed in a gap between the first IC chip and the second IC chip;
a thermal cooling device overlying the first IC chip and the second IC chip; and
a heterogeneous thermal interface material, HTIM, comprising a first thermal interface material, TIM, and a second TIM, wherein the first TIM and the second TIM are positioned adjacent one another such that they form a common edge, and wherein the first TIM overlies the first IC chip and the second TIM overlies the second IC chip, the HTIM bonding the first and second IC chips to the thermal cooling device,
wherein the first TIM comprises a material having a first thermal conductivity and a first modulus of elasticity, wherein the first TIM reflows when the first TIM reaches a first TIM reflow temperature; and
wherein the second TIM comprises at least a polymer material, the second TIM having a second modulus of elasticity greater than the first modulus of elasticity and a second thermal conductivity less than the first thermal conductivity.

2. The chip package assembly of claim 1, wherein first IC chip is a high-power chip and the second IC chip is a laterally adjacent low-power chip.

3. The chip package assembly of claim 1 or claim 2, wherein a top surfaces of the first IC chip, a top surface of the second IC chip, and a top surface of the fill material are substantially coplanar, such that the top surfaces of the first IC chip, the second IC chip and the fill material are substantially coplanar and form a TIM deposition surface, and the first TIM and the second TIM overlying the TIM deposition surface.

4. The chip package assembly of claim 3, wherein the common edge overlies the fill material; and/or
wherein at least one of the first TIM or the second TIM extends beyond a first outer peripheral edge of the first IC chip or a second outer peripheral edge of the second IC chip; and/or
wherein an outermost edge of the second TIM creates a boundary to inhibit reflowed first TIM from flowing onto a component adjacent the first IC chip.

5. The chip package assembly of any one of claims 1 to 4, wherein a material comprising the second TIM enables the second TIM to withstand a greater range of a variation in mechanical properties than the material comprising the first TIM, the second TIM being capable of absorbing thermal shocks imposed by silicon dynamic warpage.

6. The chip package assembly of any one of claims 1 to 5, further comprising a third IC chip generating heat at a third temperature less than the first temperature, wherein the second IC chip and the third IC chip are positioned on opposite sides of the first IC chip, and the second TIM is also applied to the third IC chip; and/or
wherein the thermal cooling device comprises a heatsink, and the first TIM conducts heat from the first IC chip to the heat sink; and/or
wherein the first TIM extends across an entire rear surface of the first IC chip and the second TIM extends across an entire rear surface of the second IC chip.

7. The chip package assembly of any one of claims 1 to 6, wherein the first IC chip is positioned along a neutral axis extending vertically through a central portion of the substrate and the second IC chip is spaced further away from the neutral axis than the first IC chip; and/or
wherein the first thermal conductivity is greater than 50 W/(m·K).

8. The chip package assembly of claim 2, wherein the high-power chip generates heat at a temperature of at least 80°C.

9. The chip package assembly of claim 8, wherein the low-power chip generates heat at a temperature ranging from 50°C to 70°C.

10. The chip package assembly of any one of claims 1 to 9, wherein the first TIM is comprised of a material having a metallic component, and wherein the first TIM and the second TIM diffuse along the common edge.

11. The chip package assembly of claim 10, the first TIM comprises a solder TIM, STIM, and the first TIM and the second TIM are diffusion soldered along the common edge.

12. The chip package assembly of any one of claims 1 to 11, and the second IC chip is a plurality of second IC chips, wherein at least some of the plurality of second IC chips is positioned adjacent the first IC chip.

13. An integrated circuit, IC, chip package assembly comprising:
a substrate;
a first high-power logic chip coupled to the substrate and generating heat at a first temperature;
a plurality of second low-power memory chips spaced apart from and positioned laterally adjacent the first IC chip along a same plane, the plurality of second IC chips each generating heat at a second temperature less than the first temperature;
a fill material disposed in gaps between the high-power logic chip and the plurality of second low power memory chips such that a top surface of the fill material is coplanar with the top surface of the first high-power logic chip and the top surfaces of the plurality of second low-power memory chips; and
a heterogeneous thermal interface material, HTIM, comprising a first thermal interface material, TIM, and a second TIM, wherein the first TIM and the second TIM are positioned adjacent one another such that they form a common edge, and wherein the first TIM overlies the first IC chip and the second TIM overlies the plurality of second low-power memory chips,
wherein the first TIM comprises a material having a first thermal conductivity and a first modulus of elasticity, wherein the first TIM reflows when the first TIM reaches a first TIM reflow temperature; and
wherein the second TIM comprises at least a polymer material, the second TIM having a second modulus of elasticity greater than the first modulus of elasticity and a second thermal conductivity less than the first thermal conductivity.

14. The chip package assembly of claim 13, further comprising a thermal cooling device overlying the first IC chip and the plurality of second IC chips.

15. The chip package assembly of claim 14, wherein the first TIM and the second TIM diffuse along the common edge.
